# EUROPÄISCHE PATENTSCHRIFT

(11) **EP 3 458 868 B1**
(45) Veröffentlichungstag und Bekanntmachung des Hinweises auf die Patenterteilung: **04.12.2019**
(21) Anmeldenummer: 18745840.1
(22) Anmeldetag: 10.07.2018
(51) Int. Cl.: G01R 33/30

(54) **TRANSPORTEINRICHTUNG FÜR EINEN NMR MAS ROTOR IN EINEN PROBENKOPF ("MAS SHUTTLE")**
TRANSPORT DEVICE FOR AN NMR MAS ROTOR IN A PROBE HEAD ("MAS SHUTTLE")
DISPOSITIF DE TRANSPORT POUR UN ROTOR RMN MAS DANS UNE TÊTE DE SONDE (« MAS SHUTTLE »)

(30) Priorität: 17.07.2017 DE 102017212192
(43) Veröffentlichungstag der Anmeldung: 27.03.2019
(73) Patentinhaber: Bruker Switzerland AG, 8117 Fällanden (CH)
(72) Erfinder: DE VRIES, Jonathan, 8052 Zürich (CH); SIEBER, Sven, 8607 Seegräben (CH); MEISTER, Roger, 8132 Hinteregg (CH)
(74) Vertreter: Kohler Schmid Möbus Patentanwälte
(86) Internationale Anmeldenummer: PCT/EP2018/068679
(87) Internationale Veröffentlichungsnummer: WO 2019/016035

(56) Entgegenhaltungen:
- DE-B3-102014 201 076

## Beschreibung

Die Erfindung betrifft ein System umfassend einen NMR MAS-Probenkopf eines NMR-Spektrometers sowie eine Transporteinrichtung zum Transport einer NMR(=Kernspinresonanz)-Probe zum NMR MAS(=Magic Angle Spinning)-Probenkopf, wobei die Transporteinrichtung einen Transportbehälter für den NMR MAS-Rotor aufweist, welcher so ausgebildet ist, dass der NMR MAS-Rotor durch Lösen einer Verriegelungsvorrichtung freigegeben wird und an den NMR MAS-Probenkopf übergeben und von diesem entgegengenommen werden kann, und wobei eine Detektionsvorrichtung mit einer Sensorik vorhanden ist, die es ermöglicht, zu erkennen, ob der Transportbehälter aktuell mit einem NMR MAS-Rotor bestückt ist oder nicht.

Eine solche Anordnung ist bekannt aus der DE 10 2014 201 076 B3 (=Referenz[1]).

### Hintergrund der Erfindung

Die NMR-Spektroskopie stellt ein leistungsfähiges Verfahren der instrumentellen Analytik dar. Dabei werden in eine Messprobe, die sich in einem starken, statischen Magnetfeld befindet, wodurch es zur Ausrichtung von Kernspins in der Messsubstanz kommt, HF(=Hochfrequenz)-Pulse eingestrahlt, und die HF-Reaktion der Messprobe wird vermessen. Sodann werden die Informationen integral über einen gewissen Bereich der Messprobe, das sogenannte aktive Volumen, gewonnen und zur Bestimmung der chemischen Zusammensetzung ausgewertet.

Bei der NMR-Spektroskopie von Festkörperproben kommt es zu einer erheblichen Linienverbreiterung in gemessenen NMR-Spektren aufgrund von anisotropen Wechselwirkungen zwischen Kernen in der Probe. Für Festkörperproben ist es bekannt, die Messsubstanz während der NMR-Messung unter dem so genannten "Magischen Winkel" von 54,74° gegen die Richtung des statischen Magnetfelds mit hoher Frequenz (typisch einige kHz) zu rotieren (MAS, "magic angle spinning"). Dadurch kann eine Linienverbreiterung durch dipolare Wechselwirkungen und chemische Verschiebung reduziert werden.

Die Messprobe besteht in der Regel aus einem zylindrischen Probenröhrchen, genannt Rotor, das die zu untersuchende Messsubstanz in fester oder flüssiger Form enthält. Zur Messung wird der Rotor mit der Messsubstanz in einen Stator verbracht und relativ zum Stator in Rotation versetzt, wobei der Rotor im Stator schwebt. Hierfür werden üblicherweise geeignete Gasströme eingesetzt. Um HF-Pulse in die Messsubstanz einzustrahlen und/oder HF-Signale aus der Messsubstanz zu empfangen, ist eine HF-Spulenanordnung vorgesehen, die den Stator umgibt.

Demgegenüber schlägt die der bereits eingangs zitierte DE 10 2014 201 076 B3 einen Transportbehälter vor, dessen Außenkontur geometrisch so geformt ist, dass der Transportbehälter einerseits mit einem Transportsystem verwendet werden kann, welches für den Transport eines HR-NMR Sample Spinners mit eingelegtem Probenröhrchen ausgelegt ist, andererseits aber auch für den Transport eines NMR MAS-Rotors ausgelegt ist, wobei der Transportbehälter eine Verriegelungsvorrichtung für den NMR MAS-Rotor enthält, welche so ausgebildet ist, dass beim Aufsetzen des Transportbehälters auf den NMR MAS-Probenkopf der NMR MAS-Rotor durch Lösen der Verriegelungsvorrichtung freigegeben wird und an den NMR MAS-Probenkopf übergeben und von diesem entgegengenommen werden kann.

Diese verbesserte Transporteinrichtung nach Referenz [1] löst damit -etwa gegenüber dem System nach Referenz [2]- die technische Aufgabe, ohne Umbauten des Transportsystems, sondern nur durch Auswechseln des Probenkopfes, rasch zwischen NMR-Spektroskopie von Flüssigkeiten zu Festkörpern und umgekehrt wechseln zu können. In beiden Fällen kann nunmehr das gleiche Transportsystem und insbesondere auch die gleichen Automatisationsgeräte zur sequenziellen Zuführung vieler Proben ohne Umbau sowohl mit bestehenden NMR MAS-Probenköpfen als auch mit NMR MAS-Rotoren verwendet werden.

EP 1 710 595 A1 (=Referenz [3]) zeigt ein NMR-Spektrometer mit einer Transporteinrichtung zum Transport einer NMR-Probe mittels eines Transportsystems zum NMR-Probenkopf, der eine Positioniereinrichtung aufweist, die geometrisch so gestaltet ist, dass in einer NMR-Messposition der Transportbehälter relativ zum NMR-Probenkopf in einer definierten fixen Lage angeordnet ist.

Eine spezielle Ausführungsform der Transporteinrichtung gemäß der genannten DE 10 2014 201 076 B3 zeichnet sich zudem auch noch dadurch aus, dass eine zusätzliche Vorrichtung vorhanden ist, die es ermöglicht, von außen zu erkennen, ob der Transportbehälter aktuell mit einem NMR MAS-Rotor bestückt ist. Dazu soll gemäß diesem Stand der Technik ein zusätzliches Bauteil durch den in den Transportbehälter eingebrachten NMR MAS-Rotor derart verschoben werden, dass von außen am Transportbehälter von Auge oder mittels Sensoren erkannt werden kann, ob der Transportbehälter mit einem NMR MAS-Rotor bestückt ist oder nicht.

### Aufgabe der Erfindung

Der vorliegenden Erfindung liegt demgegenüber die Aufgabe zugrunde, ein System der eingangs definierten Art mit möglichst einfachen technischen Maßnahmen so zu modifizieren, dass keine mechanischen Verschiebungen und auch keine zusätzlichen bewegten Bauteile für eine berührungsfreie, sichere Erkennung der aktuellen Bestückung des Transportbehälters -also für eine Anwesenheitsdetektion des NMR MAS-Rotors im Transportbehälter- mehr erforderlich sind.

### Kurze Beschreibung der Erfindung

Diese komplexe Aufgabe wird auf ebenso überraschend einfache wie wirkungsvolle Weise dadurch gelöst, dass bei einem gattungsgemäßen System mit den eingangs definierten Merkmalen der NMR MAS-Probenkopf eine Positioniervorrichtung aufweist, die geometrisch so gestaltet ist, dass in einer Messposition der Transportbehälter relativ zum NMR MAS-Probenkopf in einer definierten Lage angeordnet ist, und dass die Detektionsvorrichtung eine Sensorik umfasst, die eine sichere, berührungsfreie Anwesenheitsdetektion des NMR MAS-Rotors im Transportbehälter ermöglicht, sowie mindestens eine Sensorleitung, die ein von der aktuellen Relativposition des Transportbehälters zum NMR MAS-Probenkopf abhängiges Signal für eine Erkennung der aktuellen Bestückung des Transportbehälters aus dem NMR MAS-Probenkopf zum Transportbehälter leiten kann.

Das erfindungsgemässe System weist also im Gegensatz zur bisher üblichen Ausführung eine spezielle, im Shuttle-System sowie im Probenkopf vorgesehene Sensorik auf, die eine sichere, berührungsfreie Anwesenheitsdetektion des NMR MAS-Rotors im Transportbehälter ermöglicht, ohne dass dazu mechanisch bewegte Bauteile erforderlich sind.

Gerade aufgrund der durch die Erfindung eröffneten Möglichkeiten einer solchen ohne weiteres automatisierbaren Detektion der aktuellen Bestückungssituation des Systems wird dem Entwickler ein besonders wirkungsvolles Werkzeug zur ganz speziellen -und gegebenenfalls auch extremen- Auslegung eines NMR-MAS-Spektrometers an die Hand gegeben.

An dieser Stelle sei ausdrücklich darauf hingewiesen, dass sich die Vorteile der Erfindung nicht nur bei vertikalen NMR-Spektrometern, sondern ebenso auch bei NMR-Systemen mit horizontaler oder schräg liegender z-Achse erzielen lassen. Die angegebenen axialen Positionen müssen dann nicht mehr notwendig "oberhalb" beziehungsweise "unterhalb" des NMR-Spulensystems liegen, sondern gegebenenfalls auch "rechts" oder "links" neben demselben. Jedenfalls spielt die Schwerkraft bei der Wirkungsweise der vorliegenden Erfindung eine untergeordnete Rolle.

### Bevorzugte Ausführungsformen der Erfindung

Bei bevorzugten Ausführungsformen des erfindungsgemäßen Systems ist die Sensorleitung aus mehreren Abschnitten aufgebaut, wobei ein erster Abschnitt der Sensorleitung im Transportbehälter -vorzugsweise starr- eingebaut ist und von der Position des NMR MAS-Rotors im Transportbehälter zum NMR MAS-Probenkopf verläuft, und wobei ein zweiter Abschnitt der Sensorleitung im NMR MAS-Probenkopf eingebaut ist und in der Messposition unmittelbar an den ersten Abschnitt anschließt.

In der Praxis bewährt sich besonders eine erste Klasse von Ausführungsformen des erfindungsgemässen Systems, bei denen die Sensorleitung der Detektionsvorrichtung mindestens einen im NMR MAS-Probenkopf angeordneten Lichtleiter zur Weiterleitung eines optischen Signals umfasst. Ein wesentlicher Vorteil eines solchen Lichtleiters als Sensorleitung besteht darin, dass man mit der entsprechenden Sensorik die optischen Signale aufnehmen kann und somit bereit ist für eine automatisierte Anwendung.

Bei einer ersten Gruppe von Weiterbildungen dieser ersten Klasse von Ausführungsformen enthält die Sensorleitung der Detektionsvorrichtung mindestens eine optische Faser und die Detektionsvorrichtung ist für ein reflektives optisches Messverfahren zur Ermittlung der aktuellen Relativposition des NMR MAS-Rotors im Transportbehälter eingerichtet. Bei einem derartigen optischen Leiters sind die Signale besonders störungsunempfindlich, insbesondere gegen die bei der NMR unerlässlichen starken Magnetfelder.

Bei einer zweiten, zur ersten Gruppe alternativen Gruppe von Weiterbildungen enthält die Sensorleitung der Detektionsvorrichtung mindestens zwei optische Fasern, wobei die Detektionsvorrichtung für ein Durchlicht-Messverfahren zur Ermittlung der aktuellen Relativposition des NMR MAS-Rotors im Transportbehälter eingerichtet ist. Ein solches Durchlicht-Verfahren mit 2 Leitern ist prozesssicherer als eine Variante mit Reflexion (1 Leiter). Man ist unabhängig von der Reflexionsoberfläche (Farbe, Struktur etc.).

Je nach speziellem Einsatzzweck kann alternativ auch eine zweite Klasse von Ausführungsformen der erfindungsgemäßen Transporteinrichtung von Nutzen sein, bei der die Sensorleitung der Detektionsvorrichtung mindestens einen im NMR MAS-Probenkopf angeordneten elektrischen Leiter zur Weiterleitung eines elektrischen Signals umfasst. Der Vorteil einer elektrischen Sensorleitung besteht darin, dass man mit der entsprechenden Sensorik die Signale elektrisch aufnehmen kann und somit bereit ist für eine automatisierte Anwendung. Zudem ist die elektrische Lösung in der Regel kostengünstiger als die optische.

Bei einer ersten Gruppe von Weiterbildungen dieser zweiten Klasse von Ausführungsformen ist die Detektionsvorrichtung für ein elektrisches, insbesondere für ein kapazitives, Messverfahren zur Ermittlung der aktuellen Relativposition des NMR MAS-Rotors im Transportbehälter eingerichtet. Mit einer entsprechenden Sensorik elektrische Signale aufgenommen und für einen automatisierten Betrieb des NMR-MAS-Spektrometers eingesetzt werden.

Bei einer zweiten, zur ersten Gruppe alternativen Gruppe von Weiterbildungen ist die Detektionsvorrichtung für ein opto-elektrisches Messverfahren zur Ermittlung der aktuellen Relativposition des NMR MAS-Rotors im Transportbehälter eingerichtet. Während die eigentliche Detektion auf optischem Wege erfolgt, ist die Schnittstelle zum Probenkopf rein elektrisch. Vorteilhaft kann alternativ auch eine dritte Klasse von Ausführungsformen der erfindungsgemäßen Transporteinrichtung sein, bei der die Sensorleitung der Detektionsvorrichtung mindestens einen im NMR MAS-Probenkopf angeordneten Hohlleiter zur Weiterleitung eines akustischen Signals umfasst. Die Ausführungsformen dieser dritten Klasse können dadurch bevorzugt weitergebildet werden, dass das akustische Signal ein Ultraschallsignal ist. Bei einem derartigen akustischen Leiter sind die Signale besonders unempfindlich gegen äußere Störungen, insbesondere gegen starke Magnetfelder.

Auch eine vierte Klasse von Ausführungsformen des erfindungsgemäßen Systems kann vorteilhaft sein, bei welcher die Sensorleitung der Detektionsvorrichtung mindestens einen im NMR MAS-Probenkopf angeordneten Hohlleiter zur Weiterleitung eines pneumatischen Signals, insbesondere einer Druckdifferenz, umfasst. Auch bei derartigen pneumatischen Leitern sind die Signale äußerst störungsunempfindlich, vor allem wiederum gegen Magnetfelder.

Ausführungsformen der oben beschriebenen Klassen können bei Bedarf übrigens auch miteinander kombiniert werden.

Weitere bevorzugte Ausführungsformen des erfindungsgemäßen Systems sind dadurch gekennzeichnet, dass die Verriegelungsvorrichtung eine Nocke aufweist, die entlang einer Kulisse auf einer schrägen Fläche gleiten kann und in der Messposition in eine Ausnehmung einrastet. Durch die Ausrichtung ergibt sich eine saubere Kontaktierung und/oder Ausrichtung der Sensorleitungen zwischen dem Transportbehälter und dem Probenkopf.

Bei vorteilhaften Weiterbildungen dieser Ausführungsformen ist die Verriegelungsvorrichtung so gestaltet, dass die Nocke bei ihrem Einrasten in die Ausnehmung einen Stößel betätigt, durch den der NMR MAS-Rotor entriegelt wird, so dass er aus dem Transportbehälter in den NMR MAS-Probenkopf gleiten kann. Dies ermöglicht auf besonders einfache Weise eine Automatisierung des Spektrometer-Betriebs.

Alternativ oder ergänzend kann bei anderen Weiterbildungen die Nocke bei ihrem Einrasten in die Ausnehmung den Transportbehälter relativ zum NMR MAS-Probenkopf so positionieren, dass der erste Abschnitt der Sensorleitung mit dem zweiten Abschnitt fluchtet. Auch diese Maßnahme erleichtert eine Automatisierung des Spektrometer-Betriebs.

Besonders bevorzugt sind Varianten dieser sowie weiter oben beschriebener Ausführungsformen mit zwei optischen Fasern, die sich dadurch auszeichnen, dass die Nocke bei ihrem Einrasten in die Ausnehmung den Transportbehälter relativ zum NMR MAS-Probenkopf so positioniert, dass die beiden optischen Fasern koaxial ausgerichtet sind.

Vorteilhaft ist auch eine Ausführungsform des erfindungsgemäßen Systems, die sich dadurch auszeichnet, dass der Stößel in der Ausnehmung versenkbar ist. Damit wird die Vorrichtung gegen ein unbeabsichtigtes Auslösen geschützt.

In der Praxis bewähren sich schließlich auch Ausführungsformen des erfindungsgemäßen Systems, bei denen an einem Ende des Transportbehälters eine Transportschnittstelle vorgesehen ist, an welche, insbesondere geometrisch und/oder elektrisch und/oder pneumatisch, jeweils unterschiedlich ausgestaltete Adapter für NMR-Automaten montiert werden können. Vorzugsweise ist der Adapter für eine Standard USC CAP des unter dem Produktnamen "SampleJet" von der Anmelderin aktuell angebotenen NMR-MAS-Spektrometers ausgelegt.

In den Rahmen der vorliegenden Erfindung fällt auch eine NMR-Messanordnung mit einer erfindungsgemäßen Transporteinrichtung der oben beschriebenen Art, die auch ein NMR-Magnetsystem und gegebenenfalls ein Shimsystem sowie einen Kryostaten umfassen kann.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1: eine schematische Seitenansicht auf eine eine erste Transporteinrichtung, welche in einem erfindungsgemässen System Verwendung findet, sowie eines NMR-MAS-Probenkopfes vor einer Ankopplung des Transportbehälters an den Probenkopf (links in vertikaler Schnittdarstellung, rechts in seitlicher Draufsicht von außen);
- Fig. 2: eine schematische Seitenansicht auf einen zweiten Transportbehälter für ein erfindungsgemässes System (rechts in vertikaler Schnittdarstellung, links in seitlicher Draufsicht von außen); und
- Fig. 3: eine schematische vertikale Schnittansicht auf ein NMR-MAS-Spektrometer nach dem Stand der Technik.

Die vorliegende Erfindung befasst sich mit dem einer speziell modifizierten Transporteinrichtung zum Transport einer NMR-Probe in ein NMR-MAS-Spektrometer, bei welcher keine mechanischen Verschiebungen und auch keine zusätzlichen bewegten Bauteile für eine berührungsfreie, sichere Erkennung der aktuellen Bestückung des Transportbehälters -also für eine Anwesenheitsdetektion des NMR MAS-Rotors im Transportbehälter- mehr erforderlich sind.

Ein NMR-MAS-Spektrometer weist in der Regel einen temperierbaren Probenkopf in einer NMR-Messanordnung auf, die ein NMR-Magnetsystem, ein Shimsystem, eine Turbine sowie eine Vorrichtung zum Transport eines MAS-Rotors mit einer Messprobe von außerhalb des NMR-Magnetsystems bis in die Messposition des MAS-Rotors im NMR-Probenkopf umfasst.

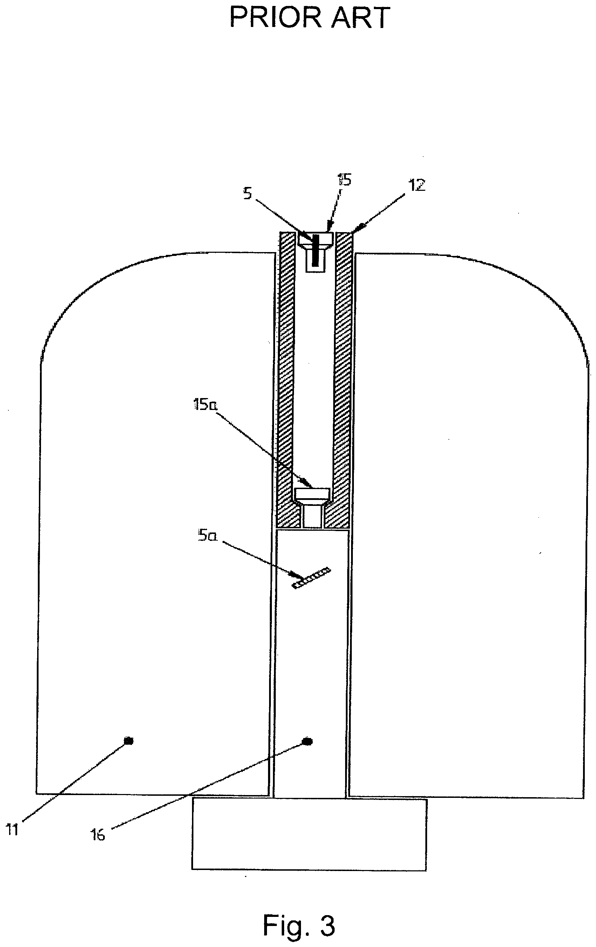

Fig. 3 zeigt schematische eine solche Anordnung für die NMR-MAS-Spektroskopie nach dem Stand der Technik unter Verwendung einer Transporteinrichtung zum Transport einer NMR-Probe mittels eines **Transportsystems 12** zum **NMR MAS-Probenkopf 16** des NMR-MAS-Spektrometers, wobei die Transporteinrichtung einen **Transportbehälter 15** sowie eine -in Fig. 3 allerdings nicht gezeigte- Verriegelungsvorrichtung für den **NMR MAS-Rotor 5** aufweist, welche so ausgebildet ist, dass beim Aufsetzen des Transportbehälters 15 auf den NMR MAS-Probenkopf 16 der NMR MAS-Rotor 5 durch Lösen der Verriegelungsvorrichtung freigegeben wird und an den NMR MAS-Probenkopf 16 übergeben und von diesem entgegen genommen werden kann, und wobei eine -in Fig. 3 ebenfalls nicht gezeigte- Detektionsvorrichtung vorhanden ist, die es ermöglicht, von außen zu erkennen, ob der Transportbehälter 15 aktuell mit einem NMR MAS-Rotor 5 bestückt ist oder nicht.

Der Probenkopf 16 ist dabei in einen **Magneten 11** eingebaut, so dass das für die NMR-Messung notwendige Magnetfeld am Ort der Messung vorhanden ist. Mit dem Transportsystem 12, wie es üblicherweise für die NMR-Spektroskopie von Festkörpern Verwendung findet, wird der mit der zu untersuchenden Substanz gefüllte NMR MAS-Rotor 5 innerhalb des Transportbehälters 15 pneumatisch zum Probenkopf 16 transportiert, durch das **Aufsetzen des Transportbehälters 15a** auf den Probenkopf 16 wird die Verriegelungsvorrichtung gelöst und der NMR MAS-Rotor 5 kann die **Messposition 5a** erreichen. Für die Messung wird im Probenkopf die Rotorachse um den "Magischen Winkel" geschwenkt. Nach der Messung wird der NMR MAS-Rotor pneumatisch aus seiner Messposition 5a zuerst in den auf dem Probenkopf aufgesetzten Transportbehälter 15a transportiert, anschließend wird der Transportbehälter mitsamt dem NMR MAS-Rotor wieder in die Ausgangsposition transportiert.

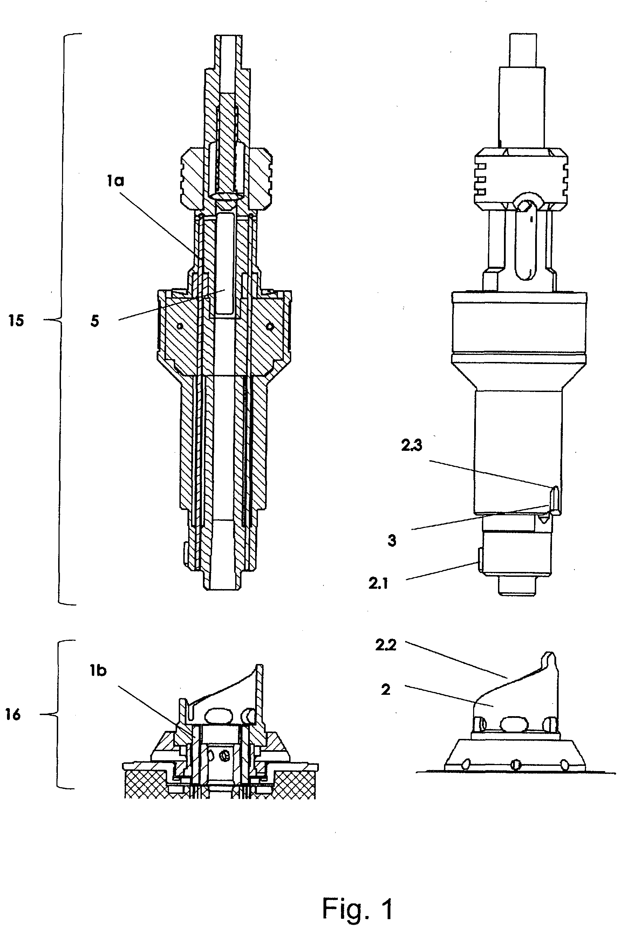

Die vorliegende Erfindung ist gegenüber diesem Stand der Technik dadurch charakterisiert, dass der NMR MAS-Probenkopf 16 -wie in Fig. 1 dargestellteine **Positioniervorrichtung 2** aufweist, die geometrisch so gestaltet ist, dass in einer Messposition der Transportbehälter 15 relativ zum NMR MAS-Probenkopf 16 in einer definierten fixen Lage angeordnet ist, dass die Detektionsvorrichtung mindestens eine aus mehreren Abschnitten 1a, 1b aufgebaute Sensorleitung umfasst, die ein von der aktuellen Relativposition des Transportbehälters 15 zum NMR MAS-Probenkopf 16 abhängiges Signal aus dem NMR MAS-Probenkopf 16 zu einem oberen, vom Probenkopf abgewandten Ende des Transportbehälters 15 leiten kann, dass ein **erster Abschnitt 1a** der Sensorleitung im Transportbehälter 15 starr eingebaut ist und von der Position des NMR MAS-Rotors 5 in einem Transportzustand des Transportbehälters 15 bis zu dem Ende des Transportbehälters 15 verläuft, wo in der Messposition der Transportbehälter 15 über die Positionier-vorrichtung 2 zum NMR MAS-Probenkopf 16 in einer definierten Lage positioniert ist, und dass ein **zweiter Abschnitt 1b** der Sensorleitung im NMR MAS-Probenkopf 16 eingebaut ist und in der Messposition unmittelbar an den ersten Abschnitt 1a anschließt und vom oberen Probenkopf-seitigen Ende der Positioniervorrichtung 2 in den NMR MAS-Probenkopf 16 hinein verläuft.

Die **Verriegelungsvorrichtung 3** für den NMR MAS-Rotor 5 wird in der Regel zweigeteilt sein und eine **Nocke 2.1** aufweisen, die entlang einer Kulisse auf einer **schrägen Fläche 2.2** gleiten kann und in der Messposition in eine **Ausnehmung 2.3** einrastet.

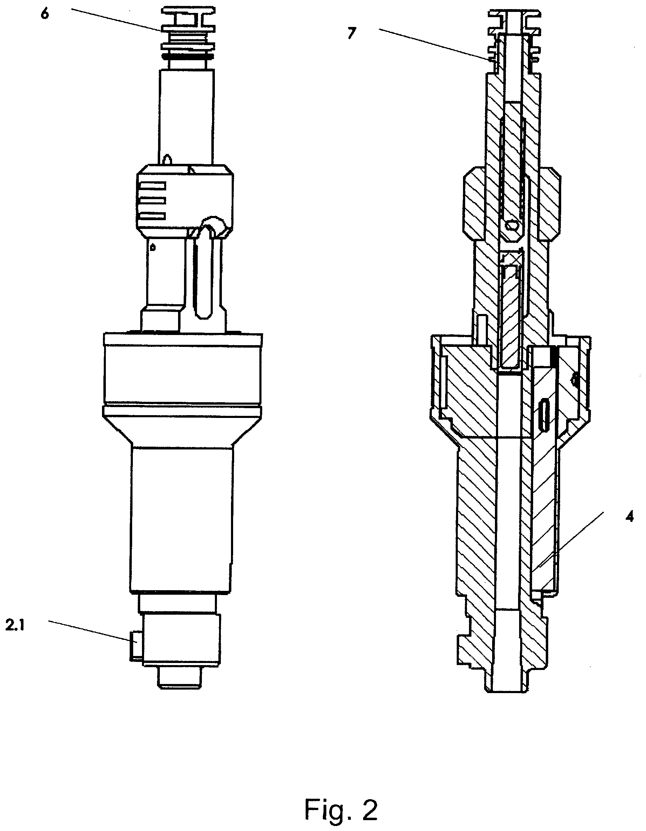

Wie in Fig. 2 zu erkennen ist, betätigt die Nocke 2.1 bei ihrem Einrasten in die Ausnehmung 2.3 einen **Stößel 4,** durch den der NMR MAS-Rotor 5 entriegelt wird, so dass er aus dem Transportbehälter 15 in den NMR MAS-Probenkopf 16 gleiten kann. Der Stößel 4 wird in der Regel in der Ausnehmung 2.3 versenkbar sein.

In der Regel wird die Nocke 2.1 bei ihrem Einrasten in die Ausnehmung 2.3 den Transportbehälter 15 relativ zum NMR MAS-Probenkopf 16 so positionieren, dass der erste Abschnitt 1a der Sensorleitung mit dem zweiten Abschnitt 1b fluchtet.

Falls die Sensorleitung der Detektionsvorrichtung mindestens zwei optische Fasern enthält, kann die Nocke 2.1 bei ihrem Einrasten in die Ausnehmung 2.3 den Transportbehälter 15 relativ zum NMR MAS-Probenkopf 16 so positionieren, dass die beiden optischen Fasern koaxial ausgerichtet sind.

Weiter ist in Fig. 2 eine Ausführungsform der erfindungsgemäßen Transporteinrichtung gezeigt, bei welcher an einem Ende des Transportbehälters 15 eine **Transportschnittstelle 7** vorgesehen ist, an welche, insbesondere geometrisch und/oder elektrisch und/oder pneumatisch, unterschiedlich ausgestaltete Adapter für NMR-Automaten montiert werden können. Vorzugsweise ist der Adapter für die im rechten Teil von Fig. 2 dargestellte **Standard USC CAP 6** des unter dem Produktnamen "SampleJet" von der Anmelderin aktuell angebotenen NMR-MAS-Spektrometers ausgelegt.

### Bezugszeichenliste:

- 1a: erster Abschnitt (1a) der Sensorleitung im Transportbehälter (15)
- 1b: zweiter Abschnitt (1b) der Sensorleitung im NMR MAS-Probenkopf (16)
- 2: Positioniervorrichtung
- 2.1: Nocke
- 2.2: schräge Fläche
- 2.3: Ausnehmung
- 3: Verriegelungsvorrichtung
- 4: Stößel
- 5: NMR MAS-Rotor
- 5a: NMR MAS-Rotor (5) in Messposition
- 6: USC CAP
- 7: Transportschnittstelle
- 11: NMR-Magnet
- 12: Transportsystem
- 15: Transportbehälter für NMR MAS-Rotoren (5)
- 15a: Transportbehälter (15), aufgesetzt auf NMR MAS-Probenkopf (16)
- 16: NMR MAS-Probenkopf

### Referenzliste:

Für die Beurteilung der Patentfähigkeit in Betracht gezogene Publikationen:
- [1]: DE 10 2014 201 076 B3
- [2]: "Z31123 Bruker Sample Transport" Version 002, Bruker BioSpin AG, Fällanden, Schweiz vom 21.November 2008
- [3]: EP 1 710 595 A1

## Patentansprüche

1. System umfassend einen NMR MAS-Probenkopf (16) eines NMR-Spektrometers sowie eine Transporteinrichtung zum Transport einer NMR-Probe zum NMR MAS-Probenkopf (16), wobei die Transporteinrichtung einen Transportbehälter (15) für den NMR MAS-Rotor (5) aufweist, welcher so ausgebildet ist, dass der NMR MAS-Rotor (5) durch Lösen einer Verriegelungsvorrichtung (3) freigegeben wird und an den NMR MAS-Probenkopf (16) übergeben und von diesem entgegen genommen werden kann, und wobei eine Detektionsvorrichtung mit einer Sensorik vorhanden ist, die es ermöglicht, zu erkennen, ob der Transportbehälter (15) aktuell mit einem NMR MAS-Rotor (5) bestückt ist oder nicht,
**dadurch gekennzeichnet,**
**dass** der NMR MAS-Probenkopf (16) eine Positioniervorrichtung (2) aufweist, die geometrisch so gestaltet ist, dass in einer Messposition der Transportbehälter (15) relativ zum NMR MAS-Probenkopf (16) in einer definierten Lage angeordnet ist,
und **dass** die Detektionsvorrichtung eine Sensorik umfasst, die eine sichere, berührungsfreie Anwesenheitsdetektion des NMR MAS-Rotors (5) im Transportbehälter (15) ermöglicht, sowie mindestens eine Sensorleitung, die ein von der aktuellen Relativposition des Transportbehälters (15) zum NMR MAS-Probenkopf (16) abhängiges Signal für eine Erkennung der aktuellen Bestückung des Transportbehälters (15) aus dem NMR MAS-Probenkopf (16) zum Transportbehälter (15) leiten kann.

2. System nach Anspruch 1, **dadurch gekennzeichnet, dass** die Sensorleitung aus mehreren Abschnitten (1a; 1b) aufgebaut ist und dass ein erster Abschnitt (1a) der Sensorleitung im Transportbehälter (15) eingebaut ist und von der Position des NMR MAS-Rotors (5) im Transportbehälter (15) zum NMR MAS-Probenkopf (16) verläuft, und dass ein zweiter Abschnitt (1b) der Sensorleitung im NMR MAS-Probenkopf (16) eingebaut ist und in der Messposition unmittelbar an den ersten Abschnitt (1a) anschließt.

3. System nach Anspruch 1 oder 2, **dadurch gekennzeichnet, dass** die Sensorleitung der Detektionsvorrichtung mindestens einen im NMR MAS-Probenkopf (16) angeordneten Lichtleiter zur Weiterleitung eines optischen Signals umfasst.

4. System nach Anspruch 3, **dadurch gekennzeichnet, dass** die Sensorleitung der Detektionsvorrichtung mindestens eine optische Faser enthält, und dass die Detektionsvorrichtung für ein reflektives optisches Messverfahren zur Ermittlung der aktuellen Relativposition des NMR MAS-Rotors (5) im Transportbehälter (15) eingerichtet ist.

5. System nach Anspruch 3, **dadurch gekennzeichnet, dass** die Sensorleitung der Detektionsvorrichtung mindestens zwei optische Fasern enthält, und dass die Detektionsvorrichtung für ein Durchlicht-Messverfahren zur Ermittlung der aktuellen Relativposition des NMR MAS-Rotors (5) im Transportbehälter (15) eingerichtet ist.

6. System nach Anspruch 1 oder 2, **dadurch gekennzeichnet, dass** die Sensorleitung der Detektionsvorrichtung mindestens einen im NMR MAS-Probenkopf (16) angeordneten elektrischen Leiter zur Weiterleitung eines elektrischen Signals umfasst.

7. System nach Anspruch 6, **dadurch gekennzeichnet, dass** die Detektionsvorrichtung für ein elektrisches, insbesondere für ein kapazitives, Messverfahren zur Ermittlung der aktuellen Relativposition des NMR MAS-Rotors (5) im Transportbehälter (15) eingerichtet ist.

8. System nach Anspruch 6, **dadurch gekennzeichnet, dass** die Detektionsvorrichtung für ein opto-elektrisches Messverfahren zur Ermittlung der aktuellen Relativposition des NMR MAS-Rotors (5) im Transportbehälter (15) eingerichtet ist.

9. System nach Anspruch 1 oder 2, **dadurch gekennzeichnet, dass** die Sensorleitung der Detektionsvorrichtung mindestens einen im NMR MAS-Probenkopf (16) angeordneten Hohlleiter zur Weiterleitung eines akustischen Signals umfasst, wobei das akustische Signal vorzugsweise ein Ultraschallsignal ist.

10. System nach Anspruch 1oder 2, **dadurch gekennzeichnet, dass** die Sensorleitung der Detektionsvorrichtung mindestens einen im NMR MAS-Probenkopf (16) angeordneten Hohlleiter zur Weiterleitung eines pneumatischen Signals, insbesondere einer Druckdifferenz, umfasst.

11. System nach einem der vorhergehenden Ansprüche, **dadurch gekennzeichnet, dass** der Transportbehälter (15) eine, vorzugsweise zweigeteilte, Verriegelungsvorrichtung (3) umfasst, welche so ausgebildet ist, dass der NMR MAS-Rotor (5) durch Lösen der Verriegelungsvorrichtung (3) beim Aufsetzen des Transportbehälters (15) auf den NMR MAS-Probenkopf freigegeben wird.

12. System nach Anspruch 11, **dadurch gekennzeichnet, dass** die Verriegelungsvorrichtung (3) eine Nocke (2.1) aufweist, die entlang einer Kulisse auf einer schrägen Fläche (2.2) gleiten kann und in der Messposition in eine Ausnehmung (2.3) einrastet.

13. System nach Anspruch 12, **dadurch gekennzeichnet, dass** die Verriegelungsvorrichtung (3) so gestaltet ist, dass die Nocke (2.1) bei ihrem Einrasten in die Ausnehmung (2.3) einen Stößel (4) betätigt, durch den der NMR MAS-Rotor (5) entriegelt wird, so dass er aus dem Transportbehälter (15) in den NMR MAS-Probenkopf (16) gleiten kann, wobei insbesondere der Stößel (4) in der Ausnehmung (2.3) versenkbar gestaltet ist.

14. System nach einem der Ansprüche 12 oder13, **dadurch gekennzeichnet, dass** die Nocke (2.1) bei ihrem Einrasten in die Ausnehmung (2.3) den Transportbehälter (15) relativ zum NMR MAS-Probenkopf (16) so positioniert, dass der erste Abschnitt (1a) der Sensorleitung mit dem zweiten Abschnitt (1b) fluchtet.

15. System nach einem der vorhergehenden Ansprüche, **dadurch gekennzeichnet, dass** an einem Ende des Transportbehälters (15) eine Transportschnittstelle (7) vorgesehen ist, an welche, insbesondere geometrisch und/oder elektrisch und/oder pneumatisch, unterschiedlich ausgestaltete Adapter für NMR-Automaten montiert werden können.

## Claims

1. System comprising an NMR MAS probe head (16) of an NMR spectrometer as well as a transport device for transporting an NMR sample to the NMR MAS probe head (16), the transport device having a transport container (15) for the NMR MAS rotor (5), which is configured in such a way that the NMR MAS rotor (5) is released by unlocking a locking apparatus (3) and is transferred to the NMR MAS probe head (16) and can be received by same, and wherein a detecting apparatus comprising a sensor system is provided, which makes it possible to detect whether or not the transport container (15) is currently loaded with an NMR MAS rotor (5),
**characterized in that**
the NMR MAS probe head (16) comprises a positioning apparatus (2), which has a geometric shape such that, in a measuring position, the transport container (15) is arranged in a defined position with respect to the NMR MAS probe head (16),
and **in that** the detecting apparatus comprises a sensor system which makes it possible to reliably detect the presence of the NMR MAS rotor (5) in the transport container (15) in a contact-free manner, and also at least one sensor line which can transmit a signal dependent on the current relative position of the transport container (15) with respect to the NMR MAS probe head (16) from the NMR MAS probe head (16) to the transport container (15) for detecting the current loading of the transport container (15).

2. System according to claim 1, **characterized in that** the sensor line is formed from a plurality of sections (1a; 1b) and that a first section (1a) of the sensor line is installed in the transport container (15) and extends from the position of the NMR MAS rotor (5) in the transport container (15) to the NMR MAS probe head (16), and that a second section (1b) of the sensor line is installed in the NMR MAS probe head (16) and directly adjoins the first section (1a) in the measurement position.

3. System according to claim 1 or 2, **characterized in that** the sensor line of the detecting apparatus comprises at least one light guide arranged in the NMR MAS probe head (16) for forwarding an optical signal.

4. System according to claim 3, **characterized in that** the sensor line of the detecting apparatus contains at least one optical fiber, and **in that** the detecting apparatus is configured for a reflective optical measurement method for determining the current relative position of the NMR MAS rotor (5) inside the transport container (15).

5. System according to claim 3, **characterized in that** the sensor line of the detecting apparatus contains at least two optical fibers, and that the detecting apparatus is configured for a transmitted light measurement method for determining the current relative position of the NMR MAS rotor (5) inside the transport container (15).

6. System according to claim 1 or 2, **characterized in that** the sensor line of the detecting apparatus comprises at least one electric conductor arranged within the NMR MAS probe head (16) for forwarding an electric signal.

7. System according to claim 6, **characterized in that** the detecting apparatus is configured for an electric, in particular for a capacitive, measurement method for determining the current relative position of the NMR MAS rotor (5) inside the transport container (15).

8. System according to claim 6, **characterized in that** the detecting apparatus is configured for an opto-electric measurement method for determining the current relative position of the NMR MAS rotor (5) inside the transport container (15).

9. System according to claim 1 or 2, **characterized in that** the sensor line of the detecting apparatus comprises at least one hollow conductor arranged within the NMR MAS probe head (16) for forwarding an acoustic signal, wherein the acoustic signal is preferably an ultrasound signal.

10. System according to claim 1 or 2, **characterized in that** the sensor line of the detecting apparatus comprises at least one hollow conductor arranged within the NMR MAS probe head (16) for forwarding a pneumatic signal, in particular a pressure difference.

11. System according to any of the preceding claims, **characterized in that** the transport container (15) comprises a locking apparatus (3), preferably formed in two parts, which is designed such that the NMR MAS rotor (5) is released by unlocking the locking apparatus (3) when the transport container (15) is disposed onto the NMR MAS probe head.

12. System according to claim 11, **characterized in that** the locking apparatus (3) has a cam (2.1), which can slide along a slotted link on an oblique surface (2.2) and which snaps into place in a recess (2.3) in the measurement position.

13. System according to claim 12, **characterized in that** the locking apparatus (3) is configured in such a way that the cam (2.1) when snapping into place in the recess (2.3) actuates a plunger (4), by means of which the NMR MAS rotor (5) is unlocked, such that it can slide out of the transport container (15) into the NMR MAS probe head (16), wherein in particular the plunger (4) is retractable in the recess (2.3).

14. System according to any of the claims 12 or 13, **characterized in that** the cam (2.1) when snapping into place in the recess (2.3) positions the transport container (15) relative to the NMR MAS probe head (16) in such a way that the first section (1a) of the sensor line is aligned with the second section (1b).

15. System according to any of the preceding claims, **characterized in that**, on one end of the transport container (15), a transport interface (7) is provided on which differently configured, in particular geometrically and/or electrically and/or pneumatically differently configured, adapters for NMR automata can be mounted.

## Revendications

1. Système comprenant une tête (16) d'échantillonnage RMN-RAM d'un spectromètre RMN, ainsi qu'un appareil de transport conçu pour acheminer un échantillon RMN vers ladite tête (16) d'échantillonnage RMN-RAM, sachant que ledit appareil de transport est muni d'un réceptacle de transport (15) affecté au rotor (5) RMN-RAM, réalisé de façon telle que ledit rotor (5) RMN-RAM soit libéré par neutralisation d'un dispositif de verrouillage (3) et puisse être transféré à ladite tête (16) d'échantillonnage RMN-RAM, par laquelle il puisse être reçu, et sachant qu'il est prévu un dispositif de détection pourvu d'un ensemble de détection permettant de repérer si ledit réceptacle de transport (15) est garni, ou non, d'un rotor (5) RMN-RAM à un instant considéré, **caractérisé par le fait**
**que** la tête (16) d'échantillonnage RMN-RAM est dotée d'un dispositif de positionnement (2) géométriquement configuré de telle sorte que le réceptacle de transport (15) occupe, en un emplacement de mesure, une position bien définie par rapport à ladite tête (16) d'échantillonnage RMN-RAM ;
et par le fait que le dispositif de détection inclut un ensemble de détection autorisant, de manière sûre et exempte de contact, une détection de présence du rotor (5) RMN-RAM dans ledit réceptacle de transport (15), ainsi qu'au moins un conducteur de détection apte à guider vers le réceptacle de transport (15), à partir de la tête (16) d'échantillonnage RMN-RAM, un signal dépendant de l'emplacement relatif effectif dudit réceptacle de transport (15) vis-à-vis de ladite tête (16) d'échantillonnage RMN-RAM, en vue d'un repérage du garnissage effectif dudit réceptacle de transport (15).

2. Système selon la revendication 1, **caractérisé par le fait que** le conducteur de détection est composé de plusieurs segments (1a ; 1b) ; **par le fait qu'**un premier segment (1a) dudit conducteur de détection est intégré dans le réceptacle de transport (15) et s'étend vers la tête (16) d'échantillonnage RMN-RAM, à partir de l'emplacement du rotor (5) RMN-RAM dans ledit réceptacle de transport (15) ; et **par le fait qu'**un second segment (1b) dudit conducteur de détection est intégré dans ladite tête (16) d'échantillonnage RMN-RAM, et se trouve dans la continuité directe dudit premier segment (1a) à l'emplacement de mesure.

3. Système selon la revendication 1 ou 2, **caractérisé par le fait que** le conducteur de détection du dispositif de détection inclut au moins un guide de lumière logé dans la tête (16) d'échantillonnage RMN-RAM, en vue de la transmission d'un signal optique.

4. Système selon la revendication 3, **caractérisé par le fait que** le conducteur de détection du dispositif de détection renferme au moins une fibre optique ; et **par le fait que** ledit dispositif de détection est agencé en vue d'un procédé de mesure optique par réflexion, afin de spécifier l'emplacement relatif effectif du rotor (5) RMN-RAM dans le réceptacle de transport (15).

5. Système selon la revendication 3, **caractérisé par le fait que** le conducteur de détection du dispositif de détection renferme au moins deux fibres optiques ; et **par le fait que** ledit dispositif de détection est agencé en vue d'un procédé de mesure par lumière transmise, afin de spécifier l'emplacement relatif effectif du rotor (5) RMN-RAM dans le réceptacle de transport (15).

6. Système selon la revendication 1 ou 2, **caractérisé par le fait que** le conducteur de détection du dispositif de détection inclut au moins un conducteur électrique logé dans la tête (16) d'échantillonnage RMN-RAM, en vue de la transmission d'un signal électrique.

7. Système selon la revendication 6, **caractérisé par le fait que** le dispositif de détection est agencé en vue d'un procédé de mesure électrique, notamment capacitif, afin de spécifier l'emplacement relatif effectif du rotor (5) RMN-RAM dans le réceptacle de transport (15).

8. Système selon la revendication 6, **caractérisé par le fait que** le dispositif de détection est agencé en vue d'un procédé de mesure opto-électrique, afin de spécifier l'emplacement relatif effectif du rotor (5) RMN-RAM dans le réceptacle de transport (15).

9. Système selon la revendication 1 ou 2, **caractérisé par le fait que** le conducteur de détection du dispositif de détection inclut au moins un conducteur creux logé dans la tête (16) d'échantillonnage RMN-RAM, en vue de la transmission d'un signal acoustique, lequel signal acoustique se présente, de préférence, comme un signal ultrasonore.

10. Système selon la revendication 1 ou 2, **caractérisé par le fait que** le conducteur de détection du dispositif de détection inclut au moins un conducteur creux logé dans la tête (16) d'échantillonnage RMN-RAM, en vue de la transmission d'un signal pneumatique, en particulier d'une différence de pression.

11. Système selon l'une des revendications précédentes, **caractérisé par le fait que** le réceptacle de transport (15) inclut un dispositif de verrouillage (3) scindé, de préférence, en deux parties et réalisé de façon telle que le rotor (5) RMN-RAM soit libéré, par neutralisation dudit dispositif de verrouillage (3), lors de la mise en place dudit réceptacle de transport (15) sur la tête d'échantillonnage RMN-RAM.

12. Système selon la revendication 11, **caractérisé par le fait que** le dispositif de verrouillage (3) est muni d'une came (2.1) qui peut glisser le long d'une pièce de coulissement, sur une surface inclinée (2.2), et s'encliquette dans un évidement (2.3) à l'emplacement de mesure.

13. Système selon la revendication 12, **caractérisé par le fait que** le dispositif de verrouillage (3) est configuré de telle sorte que la came (2.1) actionne, lors de son encliquetage dans l'évidement (2.3), un coulisseau (4) par l'intermédiaire duquel le rotor (5) RMN-RAM est déverrouillé afin qu'il puisse glisser dans la tête (16) d'échantillonnage RMN-RAM, à partir du réceptacle de transport (15), sachant notamment que ledit coulisseau (4) est conçu avec faculté d'encaissement dans ledit évidement (2.3).

14. Système selon l'une des revendications 12 ou 13, **caractérisé par le fait que**, lors de son encliquetage dans l'évidement (2.3), la came (2.1) positionne le réceptacle de transport (15), par rapport à la tête (16) d'échantillonnage RMN-RAM, de telle manière que le premier segment (1a) du conducteur de détection soit aligné avec le second segment (1b).

15. Système selon l'une des revendications précédentes, **caractérisé par** la présence, à une extrémité du réceptacle de transport (15), d'un interface de transport (7) au niveau duquel des adaptateurs de conceptions différentes, dévolus à des automates RMN, peuvent être montés en particulier géométriquement et/ou électriquement et/ou pneumatiquement.
